# EUROPEAN PATENT APPLICATION

(11) **EP 2 151 717 A1**
(43) Date of publication of application: **10.02.2010**
(21) Application number: 09165369.1
(22) Date of filing: 14.07.2009
(51) Int. Cl.: G03F 7/20

(54) **Full wafer width scanning using step and scan system**

(30) Priority: 05.08.2008 US 86347 P
(71) Applicant: ASML Holding N.V., 5504 DR Veldhoven (NL)
(72) Inventor: Sewell, Harry, Ridgefield, 6877 (US)
(74) Representative: Slenders, Petrus J. W.

(57) **Abstract**

A system and method arc provided for writing a pattern onto a substrate. A patterned beam of radiation is produced using a reticle and projected onto a substrate to expose the pattern. The respective scanning speeds of the reticle and the substrate are controlled to allow the pattern to be exposed across an entire width of the substrate in the scanning direction, while providing a substantial increase in wafer throughput.

## Description

### BACKGROUND

### Field of the Invention

The present invention relates to a lithographic apparatus and device manufacturing method.

### Related Art

A lithographic apparatus is a machine that applies a desired pattern onto a substrate, usually onto a target portion of the substrate. A lithographic apparatus can be used, for example, in the manufacture of integrated circuits (ICs), memory chips, flat panel displays, etc. In that instance, a patterning device, which is alternatively referred to as a mask or a reticle, may be used to generate a pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include steppers, in which each target portion is irradiated by exposing an entire pattern onto the target portion at one time, and scanners, in which each target portion is irradiated by scanning the pattern through a radiation beam in a given direction (the "scanning" direction), while synchronously scanning the substrate parallel or anti parallel to this direction. It is also possible to transfer the pattern from the patterning device to the substrate by contact printing, proximity printing, or imprinting the pattern onto the substrate.

In a manufacturing process using a lithographic projection apparatus, a pattern (e.g., in a mask) is imaged onto a substrate that is at least partially covered by a layer of radiation-sensitive material (resist) by the changes of either optical properties or surface physical properties of the resist. Alternatively, the imaging may use a resistless process, such as hard mask grating or nano-imprint technology. Prior to this imaging, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g., an IC. Such a patterned layer may then undergo various processes such as etching, ion-implantation (doping), metallization, oxidation, chemical-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique, such as dicing or sawing, where the individual devices can be mounted on a carrier, connected to pins, etc..

Step-and-scan technology works in conjunction with a projection system that has a narrow imaging slot. Rather than expose the entire wafer at one time, individual fields are scanned onto the wafer one at a time. This is done by moving the wafer and the reticle (or light valve) that defines the pattern simultaneously and/or synchronously, such that the imaging slot is moved across the field during the scan. The reticle stage moves at a velocity that is a wafer stage velocity multiplied by optical magnification, typically 4X. A wafer stage must then be stepped between field exposures to allow multiple copies of a pattern to be exposed over the wafer surface. In this manner, the sharpness of the image projected onto the wafer is maximized.

Reticles (also known as masks or photomasks) are used to block photoresist exposure in selected areas, defining the pattern to be exposed. Reticles, and the use of reticles, can be expensive, especially for small wafer runs.

In a situation where the substrate to be exposed is that of a typical 300mm circular disk wafer, the exposure field is approximately 26mm by 33mm using 4X reduction optics in the projection system and an approximately 150mm square reticle plate. To completely cover such a wafer with a pattern, such as a very high resolution grating pattern, requires many separate exposure fields be stitched together, where the reticle stage and a wafer stage scan back and forth for each exposure field, which is also known as step and scan lithography.

A step and scan lithographic system requires that the reticle stage and wafer stage change scan direction for each exposure field This changing of direction requires a significant overhead of time for the reticle and wafer stages to ramp up to speed, ramp down from speed, and change scan direction.

### SUMMARY

Therefore, what is needed is a system and method that can generate high resolution patterns across a width of a substrate without a need to change directions of reticle and wafer stages for a separate exposure field less than the width of the substrate.

In a first embodiment of the present invention, there is provided a system to expose a pattern onto a substrate. The system accomplishes this by producing a beam of radiation wherein a reticle is configured to pattern the beam of radiation. A projection system is configured to project the patterned beam onto a substrate to expose a first pattern, where the respective scanning speeds of the reticle and substrate are controlled to allow the first pattern to be exposed across the entire width of the substrate in the scanning direction.

In another embodiment, the reticle scan speed is motionless while in yet another embodiment the reticle scan speed is slower than the scan speed of the substrate.

A further embodiment of the present invention provides the exposed pattern to be configured as tracks comprising a data bit area for a memory device.

In another embodiment an actuator is configured to rotate the substrate by 90 degrees such that the projection system may expose a second pattern which is substantially perpendicular to the first pattern. In yet another embodiment, the wafer may be rotated by a small angle, e.g., 7 to 15 degrees, to orient the grating pattern to the underlying grid pattern.

Further embodiments, features, and advantages of the present inventions, as well as the structure and operation of the various embodiments of the present invention, are described in detail below with reference to the accompanying drawings.

### BRIEF DESCRIPTION OF THE DRAWINGS/FIGURES

The accompanying drawings, which are incorporated herein and form a part of the specification, illustrate one or more embodiments of the present invention and, together with the description, further serve to explain the principles of the invention and to enable a person skilled in the pertinent art to make and use the invention.

FIGS. 1A and 1B schematically depict lithographic apparatus.

FIG. 2 illustrates a wafer scanning path to pattern individual fields for each step and scan, showing change in wafer scan direction after each field scan.

FIG. 3 illustrates a wafer scanning path to pattern an entire width of a wafer during each scan.

FIG. 4 illustrates a portion of a step and scan patterning system.

FIGS. 5A-5C illustrate example processing steps to form a trimmed exposure.

FIGS. 6A-6C illustrate exemplary processing steps in track lithography with an orthogonal second exposure.

FIG. 7 shows a pattern where spaces and lines are unequal for a flash memory substrate.

FIG. 8 shows a flowchart depicting a method for full wafer width scanning.

The present invention will now be described with reference to the accompanying drawings. In the drawings, like reference numbers can indicate identical or functionally similar elements. Additionally, the left-most digit(s) of a reference number can identify the drawing in which the reference number first appears.

### DETAILED DESCRIPTION

This specification discloses one or more embodiments that incorporate the features of this invention. The disclosed embodiment(s) merely exemplify the invention. The scope of the invention is not limited to the disclosed embodiment(s). The invention is defined by the claims appended hereto.

The embodiment(s) described, and references in the specification to "one embodiment," "an embodiment," "an example embodiment," etc., indicate that the embodiment(s) described can include a particular feature, structure, or characteristic, but every embodiment cannot necessarily include the particular feature, structure, or characteristic. Moreover, such phrases are not necessarily referring to the same embodiment. Further, when a particular feature, structure, or characteristic is described in connection with an embodiment, it is understood that it is within the knowledge of one skilled in the art to effect such feature, structure, or characteristic in connection with other embodiments whether or not explicitly described.

Embodiments of the invention can be implemented in hardware, firmware, software, or any combination thereof. Embodiments of the invention can also be implemented as instructions stored on a machine-readable medium, which can be read and executed by one or more processors. A machine-readable medium can include any mechanism for storing or transmitting information in a form readable by a machine (e.g., a computing device). For example, a machine-readable medium can include read only memory (ROM); random access memory (RAM); magnetic disk storage media; optical storage media; flash memory devices; electrical, optical, acoustical or other forms of propagated signals (e.g., carrier waves, infrared signals, digital signals, etc.), and others. Further, firmware, software, routines, instructions can be described herein as performing certain actions. However, it should be appreciated that such descriptions are merely for convenience and that such actions in fact result from computing devices, processors, controllers, or other devices executing the firmware, software, routines, instructions, etc..

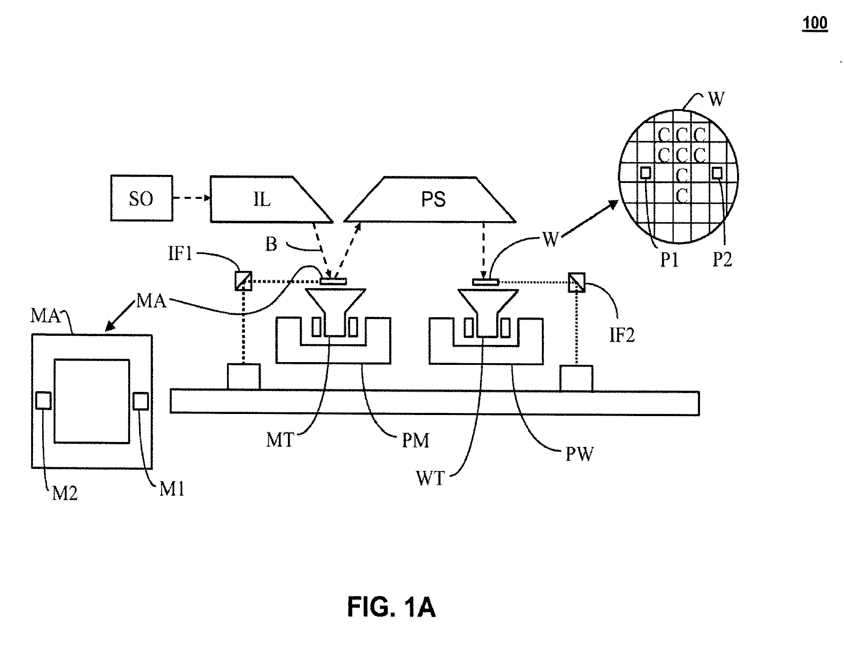

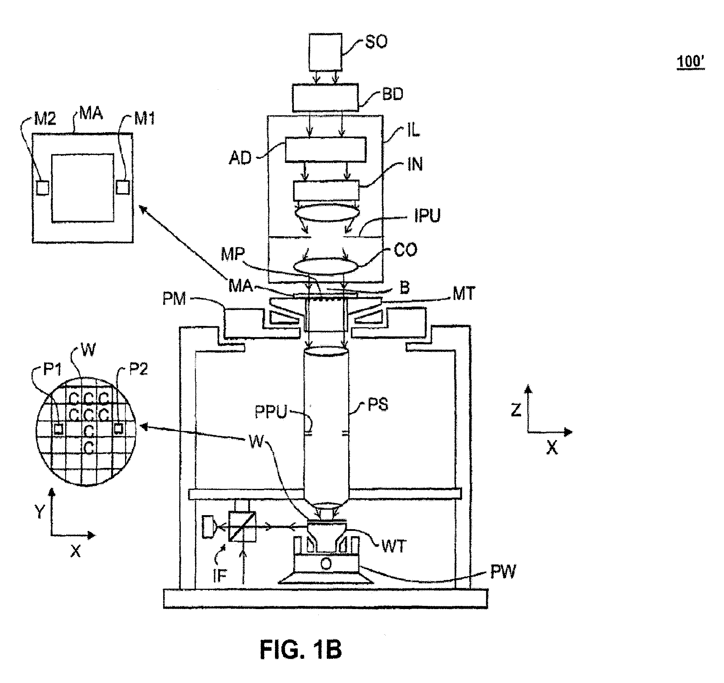

FIGS. 1A and 1B schematically depict lithographic apparatus 100 and lithographic apparatus 100', respectively. Lithographic apparatus 100 and lithographic apparatus 100' each include: an illumination system (illuminator) IL configured to condition a radiation beam B (e.g., UV, DUV or EUV radiation); a support structure (e.g., a mask table) MT configured to support a patterning device (e.g., a mask, a reticle, or a dynamic patterning device) MA and connected to a first positioner PM configured to accurately position the patterning device MA; and a substrate table (e.g., a wafer table) WT configured to hold a substrate (e.g., a resist coated wafer) W and connected to a second positioner PW configured to accurately position the substrate W. Lithographic apparatuses 100 and 100' also have a projection system PS configured to project a pattern imparted to the radiation beam B by patterning device MA onto a target portion (e.g., comprising one or more dies) C of or on the substrate W. In lithographic apparatus 100 the patterning device MA and the projection system PS is reflective, and in lithographic apparatus 100' the patterning device MA and the projection system PS is transmissive.

The illumination system IL may include various types of optical components, such as refractive, reflective, magnetic, electromagnetic, electrostatic or other types of optical components, or any combination thereof, for directing, shaping, or controlling the radiation B.

The support structure MT holds the patterning device MA in a manner that depends on the orientation of the patterning device MA, the design of the lithographic apparatuses 100 and 100', and other conditions, such as for example whether or not the patterning device MA is held in a vacuum environment. The support structure MT may use mechanical, vacuum, electrostatic or other clamping techniques to hold the patterning device MA. The support structure MT may be a frame or a table, for example, which may be fixed or movable, as required. The support structure MT may ensure that the patterning device is at a desired position, for example with respect to the projection system PS.

The term "patterning device" MA should be broadly interpreted as referring to any device that may be used to impart a radiation beam B with a pattern in its cross-section, such as to create a pattern in the target portion C of the substrate W. The pattern imparted to the radiation beam B may correspond to a particular functional layer in a device being created in the target portion C, such as an integrated circuit.

The patterning device MA may be transmissive (as in lithographic apparatus 100' of FIG. 1B) or reflective (as in lithographic apparatus 100 of FIG. 1A). Examples of patterning devices MA include reticles, masks, programmable mirror arrays, and programmable LCD panels. Masks are well known in lithography, and include mask types such as binary, alternating phase shift, and attenuated phase shift, as well as various hybrid mask types. An example of a programmable mirror array employs a matrix arrangement of small mirrors, each of which may be individually tilted so as to reflect an incoming radiation beam in different directions. The tilted mirrors impart a pattern in the radiation beam B which is reflected by the mirror matrix.

The term "projection system" PS may encompass any type of projection system, including refractive, reflective, catadioptric, magnetic, electromagnetic and electrostatic optical systems, or any combination thereof, as appropriate for the exposure radiation being used, or for other factors, such as the use of an immersion liquid or the use of a vacuum. A vacuum environment may be used for EUV or electron beam radiation since other gases may absorb too much radiation or electrons. A vacuum environment may therefore be provided to the whole beam path with the aid of a vacuum wall and vacuum pumps.

Lithographic apparatus 100 and/or lithographic apparatus 100' may be of a type having two (dual stage) or more substrate tables (and/or two or more mask tables) WT. In such "multiple stage" machines the additional substrate tables WT may be used in parallel, or preparatory steps may be carried out on one or more tables while one or more other substrate tables WT are being used for exposure. When the preparatory steps can be performed while one or more other substrate tables WT are being used for exposure, the preparatory steps are said to occur during an "in-line phase" because the preparatory steps are performed within the desired throughput of the lithographic apparatus 100 and/or lithographic apparatus 100'. In contrast, when the preparatory steps cannot be performed while one or more other substrate tables WT are being used for exposure, the preparatory steps are said to occur during an "off-line phase" because the preparatory steps cannot be performed within a desired throughput of lithographic apparatus 100 and/or lithographic apparatus 100'. Focus-positioning parameters of an exposure system (such as, for example projection system PS of lithographic apparatuses 100, 100') may be determined in an off-line phase, an in-line phase, or a combination thereof.

Referring to FIGS. 1A and 1B, the illuminator IL receives a radiation beam from a radiation source SO. The source SO and the lithographic apparatuses 100, 100' may be separate entities, for example when the source SO is an excimer laser. In such cases, the source SO is not considered to form part of the lithographic apparatuses 100 or 100', and the radiation beam B passes from the source SO to the illuminator IL with the aid of a beam delivery system BD (FIG. 1B) comprising, for example, suitable directing mirrors and/or a beam expander. In other cases, the source SO may be an integral part of the lithographic apparatuses 100 and 100', for example when the source SO is a mercury lamp. The source SO and the illuminator IL, together with the beam delivery system BD, if required, may be referred to as a radiation system.

The illuminator IL may comprise an adjuster AD (FIG. 1B) for adjusting the angular intensity distribution of the radiation beam. Generally, at least the outer and/or inner radial extent (commonly referred to as σ-outer and σ-inner, respectively) of the intensity distribution in a pupil plane of the illuminator may be adjusted. In addition, the illuminator IL may comprise various other components (FIG. 1B), such as an integrator IN and a condenser CO. The illuminator IL may be used to condition the radiation beam B, to have a desired uniformity and intensity distribution in its cross section.

Referring to FIG. 1A, the radiation beam B is incident on the patterning device (e.g., mask) MA, which is held on the support structure (e.g., mask table) MT, and is patterned by the patterning device MA. In lithographic apparatus 100, the radiation beam B is reflected from the patterning device (e.g., mask) MA. After being reflected from the patterning device (e.g., mask) MA, the radiation beam B passes through the projection system PS, which focuses the radiation beam B onto a target portion C of the substrate W. With the aid of the second positioner PW and position sensor IF2 (e.g., an interferometric device, linear encoder or capacitive sensor), the substrate table WT may be moved accurately, e.g. so as to position different target portions C in the path of the radiation beam B. Similarly, the first positioner PM and another position sensor IF1 may be used to accurately position the patterning device (e.g., mask) MA with respect to the path of the radiation beam B. Patterning device (e.g., mask) MA and substrate W may be aligned using mask alignment marks M1, M2 and substrate alignment marks P1, P2.

Referring to FIG. 1B, the radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g., an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in FIG. 1B) can be used to accurately position the mask MA with respect to the path of the radiation beam B, e.g., after mechanical retrieval from a mask library, or during a scan.

In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (known as scribe-lane alignment marks). Similarly, in situations in which more than one die is provided on the mask MA, the mask alignment marks may be located between the dies.

The lithographic apparatuses 100 and 100' may be used in at least one of the following modes:
1. In step mode, the support structure (e.g., mask table) MT and the substrate table WT are kept essentially stationary, while an entire pattern imparted to the radiation beam B is projected onto a target portion C at one time (i.e., a single static exposure). The substrate table WT is then shifted in the X and/or Y direction so that a different target portion C may be exposed.
2. In scan mode, the support structure (e.g., mask table) MT and the substrate table WT are scanned synchronously while a pattern imparted to the radiation beam B is projected onto a target portion C (i.e., a single dynamic exposure). The velocity and direction of the substrate table WT relative to the support structure (e.g., mask table) MT may be determined by the (de-)magnification and image reversal characteristics of the projection system PS.
3. In another mode, the support structure (e.g., mask table) MT is kept substantially stationary holding a programmable patterning device, and the substrate table WT is moved or scanned while a pattern imparted to the radiation beam B is projected onto a target portion C. A pulsed radiation source SO may be employed and the programmable patterning device is updated as required after each movement of the substrate table WT or in between successive radiation pulses during a scan. This mode of operation may be readily applied to maskless lithography that utilizes programmable patterning device, such as a programmable mirror array of a type as referred to herein.

Combinations and/or variations on the described modes of use or entirely different modes of use may also be employed.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion," respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g., having a wavelength of or about 435, 405, 365, 248, 193, 157 or 126 nm) or extreme ultraviolet radiation (e.g., having a wavelength of 5nm or above) or hard X-ray working at less than 5nm..

The term "lens," where the context allows, may refer to any one or combination of various types of optical components, including refractive and reflective optical components, including fresnel lenses and diffractors.

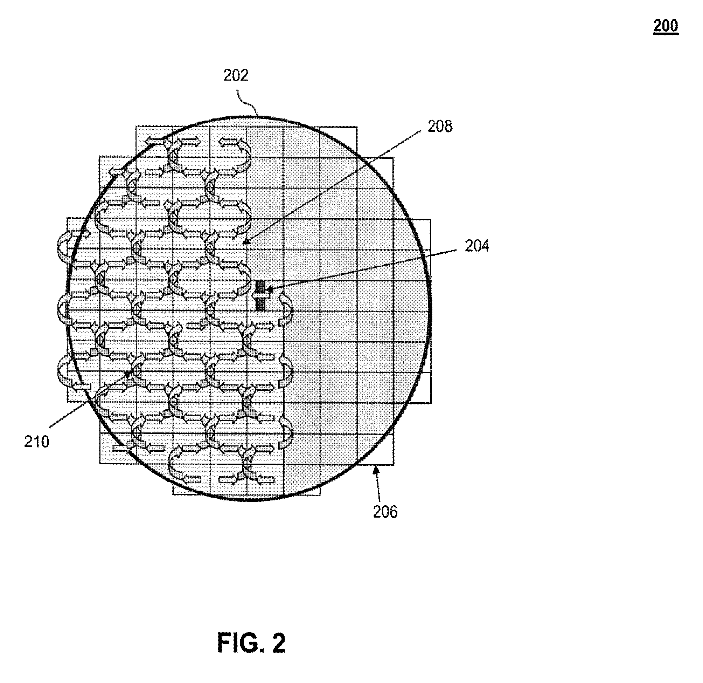

Fig. 2 illustrates a scanning path 200 to pattern individual fields on a substrate 202 (e.g., a wafer) for each step and scan. For example, path 200 may be exposed through a patterned beam exiting exposure slit 204 from the projection system (not shown, but see, e.g., FIGS. 1A and 1B) onto an exposure field 206, which may be approximately 26mm by 33mm using 4X reduction optics in the projection system and an approximately 153mm reticle (not shown, but see, e.g., FIGS. 1A and 1B). In this example, to expose an entire working surface of wafer 202 with patterns 208 (e.g., track lines) requires that multiple exposure fields 206 be stitched together. The stitching may be done through a wafer stage (not shown, but see, e.g., FIGS. 1A and 1B) and a reticle stage (not shown, but see, e.g., FIGS. 1A and 1B) being scanned back and forth for each field 206.

In the example shown in Fig. 2, twelve (12) rows of exposure fields 206 are shown, with each row consisting of up to ten (10) individual exposure fields 206. Thus, for this configuration, a 300mm wafer may have approximately 128 individual exposure fields 206. In order to pattern all 128 individual exposure fields 206, the reticle stage and the wafer stage typically change scan direction for each exposure field 206, as shown by arrows 210. Unfortunately, there can be a significant overhead time associated for each of the reticle and wafer stages to ramp up to speed, ramp down from speed, and change scan direction, since this may need to be repeated 128 times for the typical 300mm wafer.

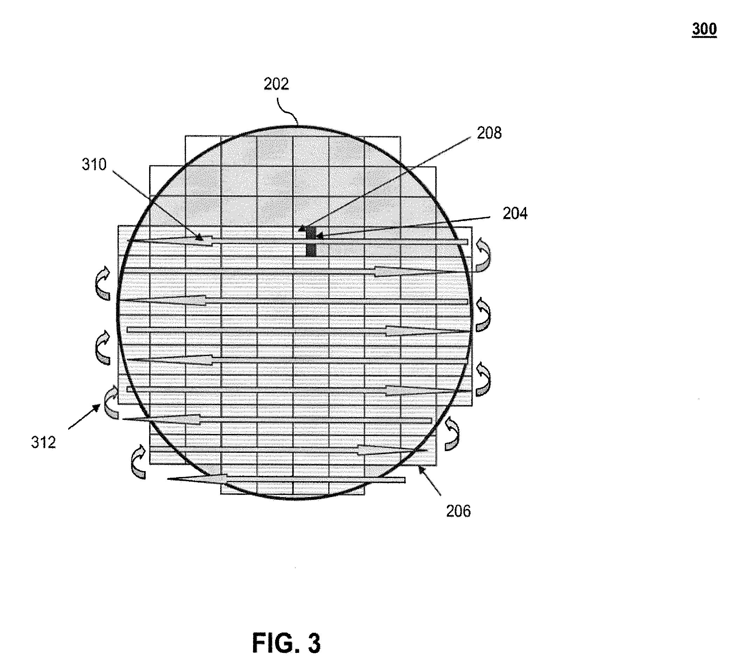

Fig. 3 shows a substantially full wafer width scanning using step and scan system illustrating a scanning path 300 from a perspective of a wafer 202 looking up into a projection system (not shown, but see FIGS. 1A and 1B) according to an embodiment of the present invention. Path 300 may be controlled in a similar matter as path 200 shown in FIG. 2, whereby a patterned beam exits exposure slit 204 from the projection system onto an exposure field 206, which may be approximately 26mm by 33mm using 4X reduction optics in the projection system and an approximately 150 mm reticle (not shown). Scanning path 300 includes the same 128 individual exposure fields 206, in 12 rows, as scanning path 200 in FIG. 2. However, in this example of FIG. 3, the exposure of the 128 individual exposure fields 206 may be accomplished by patterning a complete row (e.g., across an entire width of substrate 202) without a scan direction change, as illustrated by arrow 310. Therefore, all 128 individual exposure fields 206, in the 12 rows, can be patterned with only one change in scan direction per row, for a total of 12 scan direction changes as shown by arrows 312, to pattern the entire wafer 202.

For example, the full wafer width scanning path 300 may eliminate 116 of the ramp up, ramp down, and direction changes for the wafer and reticle stages associated with scanning path 200 as shown in Fig. 2, which is an order of magnitude reduction. The order of magnitude reduction in scan direction changes can allow the exposure operation performed for the embodiment of FIG. 3 to achieve approximately a 50% or more higher throughput because of the lower scan overhead than the exposure operation for the embodiment of FIG. 2.

Additionally, or alternatively, scanning path 300 may also allow the reticle stage to scan at a slower rate than in scanning path 200. The slower rate can result from there being one scan of the reticle with each row scan of scanning path 300. In contrast, for a conventional step and scan system with a 4X optical reduction, the reticle stage speed is four times the speed of the wafer stage as a complete scan of the reticle is required for each scan of an individual exposure field 206. However, with scanning path 300, the reticle stage speed may be reduced to less than one-third of the wafer stage speed.

In one embodiment, as the reticle stage may scan at a slower speed than the wafer stage speed, the optical magnification no longer matches the ratio of the reticle to wafer scanning speed. Because of this mismatch, the resulting one dimensional pattern is stretched and smeared in the direction of the scan to produce a smoother pattern.

It is to be appreciated that the resulting printed pattern of scanning path 300 may be one dimensional. As a one dimensional pattern, the number of sampling points necessary for alignment during an associated metrology stage is also reduced.

It is also to be appreciated that speed and acceleration of the reticle stage in a normal system is an upper limit of the system throughput. However, in the embodiments of this invention, since a reticle stage is relatively slower, a wafer scanning speed is the limiting factor of the throughput of the system.

In another embodiment, the reticle stage can be held stationary, while the wafer stage moves to along scanning path 300. Additionally, or alternatively, the reticle stage may be held stationary for an entire patterning of wafer 202 or for only a portion of a patterning.

In yet another embodiment, the reticle may be selectively scanned and stopped at various positions through the scanning path 300 to produce various desired patterns.

In yet other alternative embodiments, the scan direction of the reticle can either be the same as the scan direction of the substrate, or the directions can be opposing, depending on the desired resulting exposure (i.e., mirrored image).

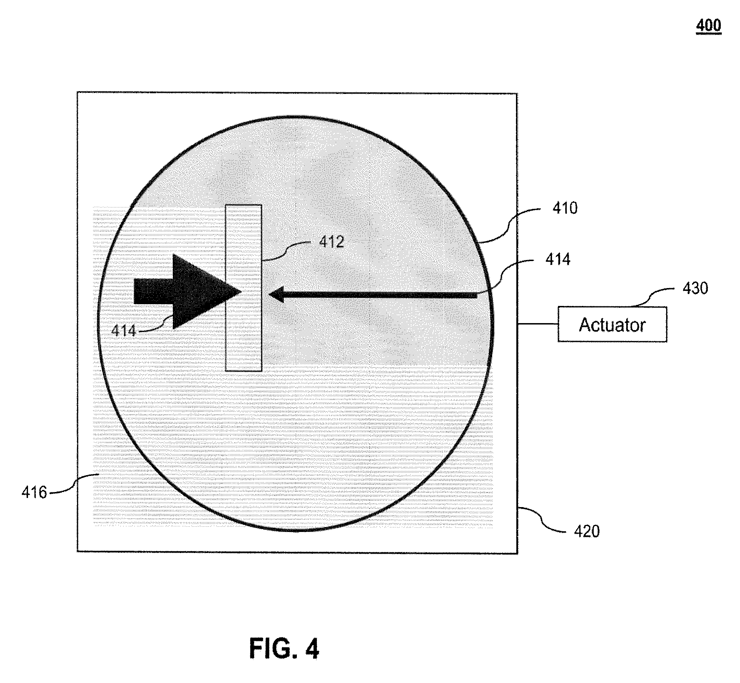

FIG. 4 shows a top view of a portion 400 of a full wafer width scanning using step and scan system, according to an embodiment of the present invention. The system includes a reticle stage (not shown, but see, e.g., FIGS. 1A and 1B), which is configured to support a reticle (not shown, but see, e.g., FIGS. 1A and 1B), which is configured to pattern beam of radiation 414. The system also includes projection optics (not shown, but see, e.g., FIGS. 1A and 1B) to project patterned beam 414 onto substrate 410 in the direction of scan 414. Portion 400 includes a substrate stage 420 that supports the substrate 410, and which is moved via an actuator 430.

In one example, patterned beam of radiation 414 may expose substrate 410 through optional slit 412. In an embodiment, slit 412 is substantially rectangular to define a rectangular field of exposure on substrate 410. However, in alternate embodiments, system 400 may include a slit of various shapes, or may not include a slit at all.

The reticle in system 400 may be configured, through the projection system, to expose substrate 410 with a track, as the pattern, along a first direction, illustrated in Fig. 4 by horizontal tracks 416. The reticle may be configured to expose a single track or a plurality of substantially parallel tracks during each scan across substrate 410.

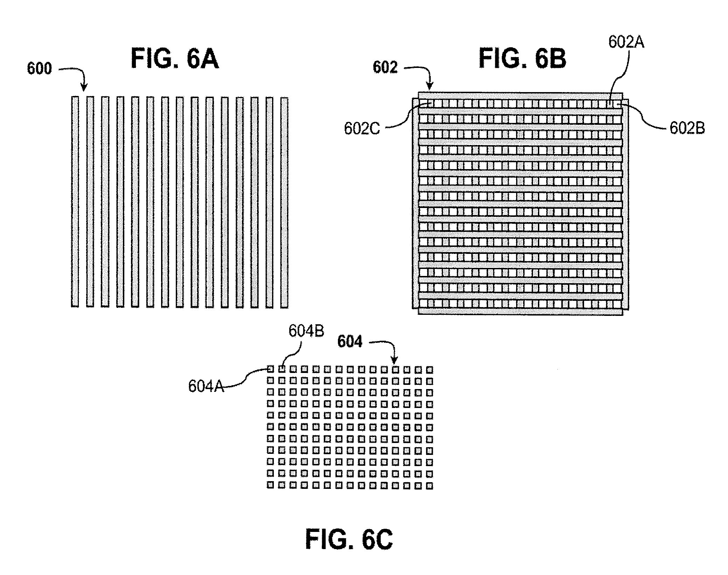

Actuator 430 is coupled to stage 420, and moves substrate 410 by moving stage 420 relative to patterned beam of radiation 414, such that one or more tracks 416 can be formed. In such a manner, a group of parallel tracks 416 can be exposed on substrate 410. Additionally, or alternatively, actuator 430 and stage 420 may rotate substrate 410 so that another set of tracks can be exposed that are substantially perpendicular to an initial set of tracks, as shown in FIGS. 6A-6C and discussed below.

In another embodiment, based on a pattern associated with the reticle, a width of tracks 416 may be varied at different positions while being formed across the width of substrate 410. Additionally, or alternatively, tracks 416 may have unequal spacing between rows as the spacing between rows is controlled by a pattern associated with the reticle.

In yet another embodiment, tracks 416 may be memory tracks formed on a memory device substrate or on a coating of a surface of the memory device substrate (e.g., a resin or the like). In this example, tracks 416 can be processed so that they comprise magnetic material that is used as a data bit area (e.g., coated with a magnetic material). In one example, tracks 416 may be isolated "island" like structures. This allows for isolated data bit areas that are relatively small and dense to be formed on the memory device substrate, while allowing the data bits to remain stable, based on their isolation from each other, when influenced by outside thermal and magnetic affects.

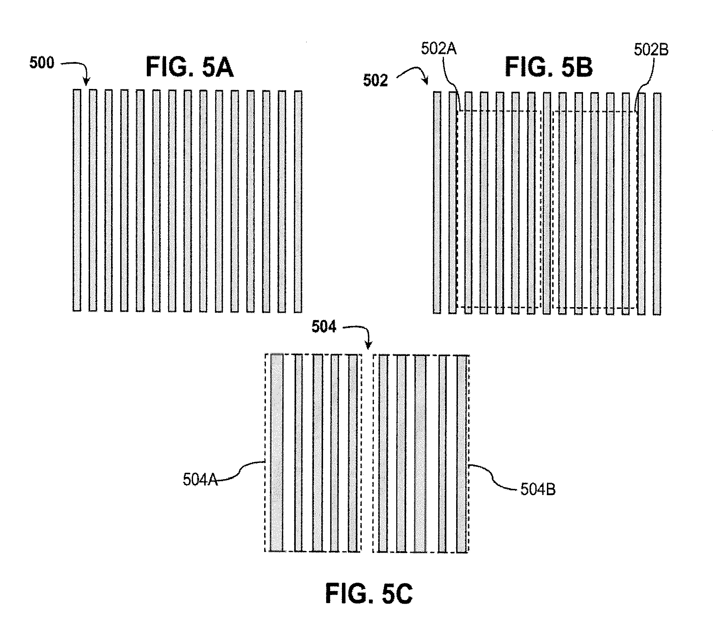

In another embodiment, a group of tracks may be trimmed to form a set of desired features on a substrate. FIGS. 5A, 5B, and 5C illustrate example processing steps to form a trimmed exposure, according to an embodiment of the present invention. In FIG. 5A, tracks 500 are formed on a substrate (not shown). In an embodiment, systems 300 and/or 400, described with reference to FIG. 4, can be used to form tracks 500. In FIG. 5B, using a trim exposure, regions 502A and 502B are selected as being the features desired in a final pattern. Regions 502A and 502B are shown in FIG. 5B to be substantially rectangular. However, as would be apparent to the skilled artisan, regions of different types of shapes can be selected. In FIG. 5C, using trim exposure developing, regions outside of selected regions 502A and 502B are removed, leaving only selected regions 504A and 504B remaining in a final pattern 504.

In a further embodiment, memory cell or grid-based lithography can be performed, in which a grid pattern is formed on a substrate and specific patterns are then formed from the grid. FIGS. 6A, 6B, and 6C show exemplary processing steps for memory cell lithography, according to an embodiment of the present invention. FIG. 6A shows tracks 600 formed on a substrate (not show, but see FIGS. 1A-4 above). As described above, tracks 600 may be formed by systems 300 and/or 400. In FIG. 6B, the substrate has been rotated 90 degrees relative to the exposure its position during the exposure in FIG. 6A, and a second set of tracks are exposed to form grid 602. The second set of tracks are substantially perpendicular to the first set of tracks 600. A region is then selected from grid 602. In FIG. 6C, similar to the trimming described with reference to FIG. 5C, regions outside of selected region are then removed. For example, the selected region may include portions of adjacent columns 602A and 602B (see FIG. 6B). To form a pattern 604 that includes columns 604A and 604B separated by spaces, column 602C (See FIG. 6B) and other similar columns (e.g., alternating columns) may also be exposed. Such a procedure is applied to the rest of the columns of the selected region to finally form pattern 604.

In an embodiment, pattern 604 can be used to form a memory cell. In alternate embodiments, similar design steps, i.e., creating a grid by exposing perpendicular sets of lines and trimming the resulting grid, can also be used to implement other structures, such as NAND and other logic components, as well as Stacked Memory technology. In one embodiment, an angle grid exposure for memory chips, with approximately a 7 to 15 degree rotation to the underlying orthogonal chip pattern, is used after exposure of the angle grid with a second exposure to trims away any unwanted pattern in order to produce the desired final pattern.

An example of an interference lithographic grid pattern, double patterning application can be found in U.S. Published Application No. 2005/0074698, which is incorporated by reference herein in its entirety.

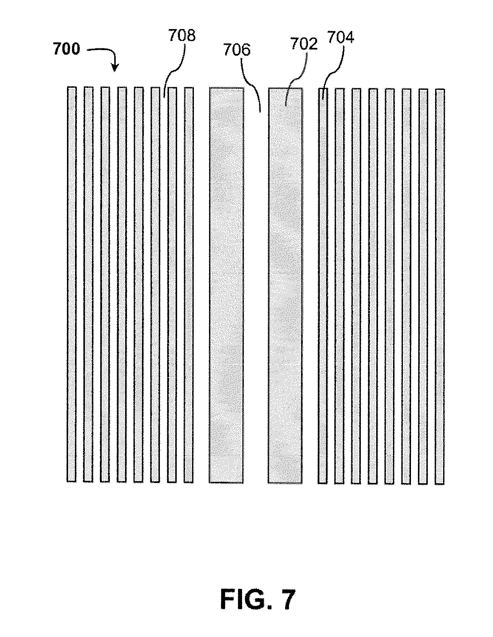

FIG. 7 shows pattern 700 where spaces and lines are unequal for a flash memory substrate. As an example, line 702 is wider than line 704, and space 706 is wide than space 708.

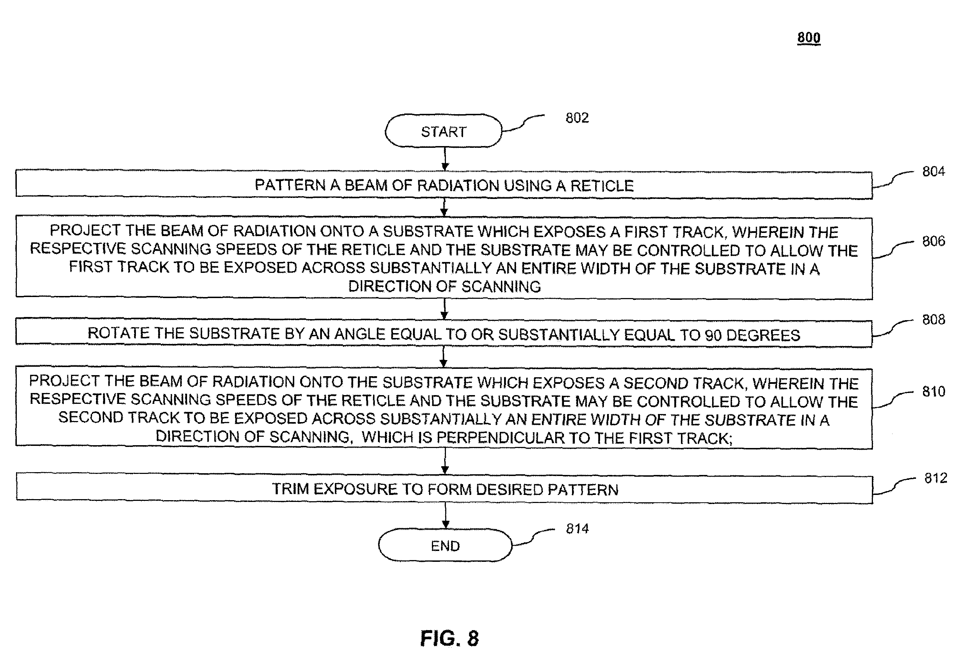

FIG. 8 shows a flowchart depicting a method 800. For example, a method of writing memory patterns onto a substrate, which may be performed using a system as described in Figures 1A, 1B, 3, and/or 4.

The method starts in block 802. In block 804, a beam of radiation is patterned using a reticle. In block 806, the patterned beam of radiation is projected onto a substrate. The resulting exposure from the patterned beam results in the exposure of a first track, wherein the respective scanning speeds of the reticle and the substrate may be controlled to allow the first track to be exposed across substantially an entire width of the substrate in a direction of scanning. In block 808, the substrate is rotated by 90 degrees. In block 810, the beam of radiation is projected onto the rotated substrate, which exposes a second track, which is substantially perpendicular to the first track, wherein the respective scanning speeds of the reticle and the substrate may be controlled to allow the second track to be exposed across substantially an entire width of the substrate in a direction of scanning.

In optional block 812, the exposed pattern is further trimmed to form a desired pattern. In a further embodiment, intersecting first and second sets of tracks may be used, for further trimming, as described with reference to FIG. 6, to form a grid that can be used as the basis for features formed on the substrate. The method ends at 814.

Although specific reference can be made in this text to the use of lithographic apparatus in the manufacture of a specific device (e.g., an integrated circuit or a memory device), it should be understood that the lithographic apparatus described herein can have other applications. Applications include, but are not limited to, the manufacture of integrated circuits, integrated optical systems, guidance and detection patterns for magnetic domain memories, flat-panel displays, liquid-crystal displays (LCDs), thin-film magnetic heads, micro-electromechanical devices (MEMS), light emitting diodes (LEDs), etc. Also, for instance in a flat panel display, the present apparatus can be used to assist in the creation of a variety of layers, e.g. a thin film transistor layer and/or a color filter layer.

Although specific reference can have been made above to the use of embodiments of the invention in the context of optical lithography, it will be appreciated that the invention can be used in other applications, for example immersion lithography. The lithographic apparatus can also be of a type wherein at least a portion of the substrate can be covered by an "immersion liquid" having a relatively high refractive index, e.g., water, so as to fill a space between the projection system and the substrate. An immersion liquid can also be applied to other spaces in the lithographic apparatus, for example, between the patterning device and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

While specific embodiments of the invention have been described above, it will be appreciated that the invention can be practiced otherwise than as described. For example, the invention can take the form of a computer program containing one or more sequences of machine-readable instructions describing a method as disclosed above, or a data storage medium (e.g. semiconductor memory, magnetic or optical disk) having such a computer program stored therein.

### Conclusion

While various embodiments of the present invention have been described above, it should be understood that they have been presented by way of example only, and not limitation. It will be apparent to persons skilled in the relevant art that various changes in form and detail can be made therein without departing from the spirit and scope of the invention. Thus, the breadth and scope of the present invention should not be limited by any of the above-described exemplary embodiments, but should be defined only in accordance with the following claims and their equivalents.

It is to be appreciated that the Detailed Description section, and not the Summary and Abstract sections, is intended to be used to interpret the claims. The Summary and Abstract sections can set forth one or more, but not all exemplary embodiments of the present invention as contemplated by the inventor(s), and thus, are not intended to limit the present invention and the appended claims in any way.

## Claims

1. A lithographic device comprising:
a reticle stage configured to support a reticle thereon, the reticle configured to pattern a beam of radiation;
a substrate stage configured to support a substrate thereon;
a projection system configured to expose the patterned beam on the substrate;
an actuator configured to move the substrate stage, and through moving the substrate stage, to move the substrate; and
a controller configured to control respective scanning speeds during scanning of the reticle stage and the substrate stage,
wherein the controller is configured to control the respective scanning speeds of the reticle stage and the substrate stage, such that a first pattern is exposed in each scanning pass across substantially an entire width of the substrate.

2. The lithographic device of claim 1, wherein the controller is configured to maintain the reticle stage substantially stationary during the scanning pass.

3. The lithographic device of claim 1, wherein the controller is configured to move the reticle stage substantially slower that the substrate stage during the scanning pass.

4. The lithographic device of claim 1, wherein a pattern formed on the reticle is configured to vary an orthogonal width of the first pattern at different positions during the scanning pass across substantially the entire width of the substrate.

5. The lithographic device of claim 1, wherein the reticle is configured to expose a plurality of simultaneous parallel patterns during the scanning pass.

6. The lithographic device of claim 1, wherein:
the substrate is configured as a memory device; and
the first pattern comprises tracks configured to be data bit areas for the memory device.

7. The lithographic device of claim 1, wherein the actuator is configured to rotate the substrate stage substantially 90 degrees between exposure of the first pattern and a second pattern, the second pattern being exposed on the substrate substantially perpendicular with respect to the first pattern.

8. The lithographic device of claim 1, wherein the actuator is configured to rotate the substrate stage between substantially 7 and 15 degrees between exposure of the first pattern and a second pattern.

9. A device manufacturing method comprising:
patterning a first beam of radiation using a reticle;
projecting the first beam of radiation onto a substrate to exposes a first pattern during a first scanning pass;
rotating the substrate substantially 90 degrees;
patterning a second beam of radiation using the reticle; and
projecting the second beam of radiation onto the substrate to expose a second pattern during a second scanning pass, the second pattern being substantially perpendicular to the first track,
wherein at least one of the first or second patterns are exposed during a respective one of the first or second scanning pass across substantially an entire width of the substrate through controlling relative speeds of the reticle and the substrate.

10. The method of claim 9, further comprising maintaining the reticle substantially stationary during at least one of the first and second scanning pass.

11. The method of claim 9, further comprising scanning the reticle slower than the substrate during at least one of the first and second scanning pass.

12. The method of claim 9, further comprising varying a width of at least one of the first or second patterns as they are formed during across the substrate.

13. The method of claim 9, further comprising exposing a plurality of at least one of the first or second patterns in parallel during a respective one of the first or second scanning passes.

14. The method of claim 9, further comprising:
using a memory device as the substrate; and
using a track as at least one of the first and second patterns, the track being configured to be data bit areas for the memory device.

15. The method of claim 11, further comprising reducing scanning overhead associated with changes in scan speed to thereby increasing throughput.
